# EUROPÄISCHE PATENTSCHRIFT

(11) **EP 1 170 804 B1**
(45) Veröffentlichungstag und Bekanntmachung des Hinweises auf die Patenterteilung: **02.04.2008**
(21) Anmeldenummer: 01115516.5
(22) Anmeldetag: 27.06.2001
(51) Int. Cl.: H01L 29/94, H01L 21/02

(54) **Grabenkondensator mit Isolationskragen und entsprechendes Herstellungsverfahren**
Trench capacitor with insulating collar and corresponding manufacturing process
Condensateur en tranchée avec anneau d'isolation et procédé de fabrication correspondant

(30) Priorität: 07.07.2000 DE 10034003
(43) Veröffentlichungstag der Anmeldung: 09.01.2002
(73) Patentinhaber: Infineon Technologies AG, 81669 München (DE)
(72) Erfinder: Seidl, Harald, 01099 Dresden (DE); Gutsche, Martin, Dr., 84405 Dorfen (DE)
(74) Vertreter: Reinhard - Skuhra - Weise & Partner

(56) Entgegenhaltungen:
- EP-A- 0 188 946
- EP-A- 0 528 281
- EP-A- 0 967 653
- US-A- 5 629 226
- US-A- 5 861 649
- US-A- 5 998 821
- US-A- 6 018 174
- US-A- 6 034 390
- PATENT ABSTRACTS OF JAPAN vol. 2000, no. 05, 14. September 2000 (2000-09-14) -& JP 2000 058777 A (SAMSUNG ELECTRONICS CO LTD), 25. Februar 2000 (2000-02-25)

## Beschreibung

Die vorliegende Erfindung betrifft einen Grabenkondensator, insbesondere zur Verwendung in einer Halbleiter-Speicherzelle, mit einem Graben, der in einem Halbleitersubstrat gebildet ist; einer im Graben befindlichen ersten und zweiten leitenden Kondensatorplatte; einer zwischen der ersten und zweiten Kondensatorplatte befindlichen dielektrischen Schicht als Kondensatordielektrikum; einem Isolationskragen im oberen Bereich des Grabens; und einem in den Graben gefüllten leitenden Füllmaterial und ein entsprechendes Herstellungsverfahren.

Das Dokument US 5,861,649 beschreibt einen Grabenkondensator für eine Halbleiter-Speicherzelle.

Obwohl auf beliebige Grabenkondensatoren anwendbar, werden die vorliegende Erfindung und die ihr zugrundeliegende Problematik nachstehend in bezug auf einen in einer DRAM-Speicherzelle verwendeten Grabenkondensator erläutert. Solche Speicherzellen werden in integrierten Schaltungen (ICs), wie beispielsweise Speichern mit wahlfreiem Zugriff (RAMs), dynamischen RAMs (DRAMs), synchronen DRAMs (SDRAMs), statischen RAMs (SRAMs) und Nur-Lese-Speichern (ROMs) verwendet. Andere integrierte Schaltungen enthalten Logikvorrichtungen, wie z.B. programmierbare Logikarrays (PLAs), anwenderspezifische ICs (ASICs), Mischlogik/ Speicher-ICs (eingebettete DRAMs) oder sonstige Schaltungsvorrichtungen. Üblicherweise wird eine Vielzahl von ICs auf einem Halbleitersubstrat, wie z.B. einem Siliziumwafer, parallel hergestellt. Nach der Verarbeitung wird der Wafer zerteilt, um die ICs in eine Vielzahl individueller Chips zu separieren. Die Chips werden dann in Endprodukte verpackt, beispielsweise zur Verwendung in Verbraucherprodukten, wie z.B. Computersystemen, zellulären Telefonen, persönlichen digitalen Assistenten (PDAs) und weiteren Produkten. Zu Diskussionszwecken wird die Erfindung hinsichtlich der Bildung einer einzelnen Speicherzelle beschrieben.

Integrierte Schaltungen (ICs) oder Chips verwenden Kondensatoren zum Zwecke der Ladungsspeicherung. Ein Beispiel eines IC, welcher Kondensatoren zum Speichern von Ladungen verwendet, ist ein Speicher-IC, wie z.B. ein Chip für einen dynamischen Schreib-/Lesespeicher mit wahlfreiem Zugriff (DRAM). Der Ladungszustand ("0" oder "1") in dem Kondensator repräsentiert dabei ein Datenbit.

Ein DRAM-Chip enthält eine Matrix von Speicherzellen, welche in Form von Zeilen und Spalten verschaltet sind. Üblicherweise werden die Zeilenverbindungen als Wortleitungen und die Spaltenverbindungen als Bitleitungen bezeichnet. Das Auslesen von Daten von den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Transistor. Der Transistor enthält zwei Diffusionsbereiche, welche durch einen Kanal getrennt sind, oberhalb dessen ein Gate angeordnet ist. Abhängig von der Richtung des Stromflusses bezeichnet man den einen Diffusionsbereich als Drain und den anderen als Source. Die Bezeichnungen "Drain" und "Source" werden hier hinsichtlich der Diffusionsbereiche gegenseitig austauschbar verwendet. Die Gates sind mit einer Wortleitung verbunden, und einer der Diffusionsbereiche ist mit einer Bitleitung verbunden. Der andere Diffusionsbereich ist mit dem Kondensator verbunden. Das Anlegen einer geeigneten Spannung an das Gate schaltet den Transistor ein, ermöglicht einen Stromfluß zwischen den Diffusionsbereichen durch den Kanal, um so eine Verbindung zwischen dem Kondensator und der Bitleitung zu bilden. Das Ausschalten des Transistors trennt diese Verbindung, indem der Stromfluß durch den Kanal unterbrochen wird.

Die in dem Kondensator gespeicherte Ladung baut sich mit der Zeit aufgrund eines inhärenten Leckstroms ab. Bevor sich die Ladung auf einen unbestimmten Pegel (unterhalb eines Schwellwerts) abgebaut hat, muß der Speicherkondensator aufgefrischt werden.

Das fortlaufende Bestreben nach Verkleinerung der Speichervorrichtungen fördert den Entwurf von DRAMs mit größerer Dichte und kleinerer charakteristischer Größe, d.h. kleinerer Speicherzellenfläche. Zur Herstellung von Speicherzellen, welche eine geringeren Oberflächenbereich besetzen, werden kleinere Komponenten, beispielsweise Kondensatoren, verwendet. Jedoch resultiert die Verwendung kleinerer Kondensatoren in einer erniedrigten Speicherkapazität, was wiederum die Funktionstüchtigkeit und Verwendbarkeit der Speichervorrichtung widrig beeinflussen kann. Beispielsweise erfordern Leseverstärker einen ausreichenden Signalpegel zum zuverlässigen Auslesen der Information in den Speicherzellen. Das Verhältnis der Speicherkapazität zur Bitleitungskapazität ist entscheidend bei der Bestimmung des Signalpegels. Falls die Speicherkapazität zu gering wird, kann dieses Verhältnis zu klein zur Erzeugung eines hinreichenden Signals sein. Ebenfalls erfordert eine geringere Speicherkapazität eine höhere Auffrischfrequenz.

Ein Kondensatortyp, welcher üblicherweise in DRAMs verwendet wird, ist ein Grabenkondensator. Ein Grabenkondensator hat eine dreidimensionale Struktur, welche in dem Siliziumsubstrat ausgebildet ist. Eine Erhöhung des Volumens bzw. der Kapazität des Grabenkondensators kann durch tieferes Ätzen in das Substrat erreicht werden. In diesem Fall bewirkt die Steigerung der Kapazität des Grabenkondensators keine Vergrö-ßerung der von der Speicherzelle belegten Oberfläche.

Ein üblicher Grabenkondensator enthält einen in das Substrat geätzten Graben. Dieser Graben wird typischerweise mit p⁺-oder n⁺-dotiertem Polysilizium gefüllt, welches als eine Kondensatorelektrode dient (auch als Speicherkondensator bezeichnet). Die zweite Kondensatorelektrode ist das Substrat oder eine "vergrabene Platte". Ein Kondensatordielektrikum, welches z.B. Nitrid enthält, wird üblicherweise zur Isolation der zwei Kondensatorelektroden verwendet.

In dem oberen Bereich des Grabens wird ein dielektrischer Kragen (vorzugsweise ein Oxidbereich) erzeugt, um einen Leckstrom zu verhindern bzw. den oberen Teil des Kondensators zu isolieren.

Das Kondensatordielektrikum wird in dem oberen Bereich des Grabens, wo der Kragen zu bilden ist, üblicherweise vor dessen Bildung entfernt, da dieser obere Teil des Kondensatordielektrikums für nachfolgende Prozeßschritte hinderlich ist.

Um die Speicherdichte für zukünftige Speichertechnolgie - Generationen weiter zu erhöhen, wird die Strukturgröße von Generation zu Generation verkleinert. Die immer kleiner werdende Kondensatorfläche und die dadurch bedingte kleiner werdende Kondensatorkapazität führt zu Problemen. Deshalb ist es eine wichtige Aufgabe, die Kondensatorkapazität trotz kleinerer Strukturgröße mindestens konstant zu halten. Dies kann unter anderem durch eine Erhöhung der Flächenladungsdichte des Speicherkondensators erreicht werden.

Bisher wurde dieses Problem einerseits durch eine Vergrößerung der zur Verfügung stehenden Kondensatorfläche bei vorgegebener Strukturgröße gelöst, beispielsweise durch eine Aufweitung des Trenches ("Wet Bottle") unterhalb des Kragens bzw. Collars oder durch eine Aufrauhung der Oberfläche im Graben. Andererseits wurde bisher die Flächenladungsdichte durch eine Verringerung der Dicke des Dielektrikums erhöht. Dabei wurden bisher als Dielektrika für Trenchkondensatoren ausschließlich verschiedene Kombinationen von SiO₂ (Siliziumdioxid) und Si₃N₄ (Siliziumnitrid) in Verbindung mit dotierten Siliziumelektroden verwendet. Eine weitere Verringerung der Dicke dieser Materialien ist aufgrund der dadurch auftretenden hohen Leckströme nicht möglich.

Daher ist es Aufgabe der vorliegenden Erfindung, einen verbesserten Grabenkondensator mit einem Isolationskragen zu schaffen, welcher eine erhöhte Flächenladungsdichte aufweist und ohne das Risiko erhöhter Leckströme herstellbar ist.

Erfindungsgemäß wird diese Aufgabe durch den in Anspruch 1 angegebenen Grabenkondensator mit einem Isolationskragen gelöst. Weiterhin wird diese Aufgabe durch das in Anspruch 10 angegebene Verfahren gelöst.

Bevorzugte Weiterbildungen sind Gegenstand der jeweiligen Unteransprüche.

Die erfindungsgemäße Vorgehensweise gemäß Anspruch 1 bzw. 10 weist gegenüber den bekannten Lösungsansätzen den Vorteil auf, daß die Flächenladungsdichte durch die Verwendung spezieller Dielektrika und/oder Elektroden im Grabenkondensator mit im Vergleich zu den bisher verwendeten Dielektrika höheren Dielektrizitätskonstanten vergrößerbar ist, ohne dabei die Leckströme zu erhöhen.

Die speziellen Dielektrika können unter anderem mit dem sogenannten Atomic Layer Deposition (ALD- bzw. ALCVD-Verfahren) ohne Probleme in Strukturen mit sehr hohen Aspektverhältnissen mit sehr guter Kantenbedeckung abgeschieden werden. Insbesondere können diese Dielektrika deshalb sehr gut mit Verfahren zur Oberflächenvergrößerung, zum Beispiel Wet Bottle, Aufrauhung der Oberfläche im Graben etc., kombiniere werden.

Die erfindungsgemäße Vorgehensweise gemäß Anspruch 1 bzw. 10 weist gegenüber den bekannten Lösungsansätzen den Vorteil auf, daß durch die Verwendung von Metallelektroden die parasitäre Kapazität der Raumladungszone eliminierbar ist.

Gemäß einer bevorzugten Weiterbildung ist die erste Kondensatorplatte ein Bereich erhöhter Dotierung im Halbleitersubstrat im unteren Bereich des Grabens, und die zweite Kondensatorplatte ist das leitende Füllmaterial.

Gemäß einer weiteren bevorzugten Weiterbildung wird im oberen Bereich des Grabens eine zweite Metallelektrodenschicht vorgesehen, welche mit der ersten Metallelektrodenschicht in elektrischer Verbindung steht.

Gemäß einer weiteren bevorzugten Weiterbildung wird im oberen Bereich des Grabens eine zweite Metallelektrodenschicht vorgesehen, welche mit der vierten Metallelektrodenschicht in elektrischer Verbindung steht.

Gemäß einer weiteren bevorzugten Weiterbildung werden die dielektrische Schicht und die vierte Metallelektrodenschicht in den Bereich des Isolationskragens geführt.

Gemäß einer weiteren bevorzugten Weiterbildung wird die dritte Metallelektrodenschicht in den Bereich des Isolationskragens geführt.

Gemäß einer weiteren bevorzugten Weiterbildung werden die erste und/ oder zweite und/ oder dritte und/ oder vierte Metallelektrodenschicht und/ oder die dielektrische Schicht durch ein ALD- bzw. ALCVD-Verfahren und/ oder ein CVD-Verfahren aufgebracht.

Gemäß einer weiteren bevorzugten Weiterbildung weist die erste und/ oder zweite und/ oder dritte und/ oder vierte Metallelektrodenschicht mindestens eines der folgenden Materialien auf: TiN, WN, TaN, HfN, ZrN, Ti, W, Ta, Si, TaSiN, WSiN, TiAlN, WSi, MoSi, CoSi oder ähnliche Materialien.

Gemäß einer weiteren bevorzugten Weiterbildung weist der Graben einen unteren aufgeweiteten Bereich auf.

Gemäß einer weiteren bevorzugten Weiterbildung weist die dielektrische Schicht mindestens eines der folgenden Materialien auf: Al₂O₃, Ta₂O₅, ZrO₂, HfO₂ Y₂O₃, La₂O_{3,} TiO₂; Al-Ta-O, Al-Zr-O, Al-Hf-O, Al-La-O, Al-Ti-O, Zr-Y-O, Zr-Si-O, Hf-Si-O, Si-O-N, Ta-O-N, Gd₂O₃, SnO₃, La-Si-O, Ti-Si-O, LaAlO₃, ZrTiO₄, (Zr,Sn)TiO₄, SrZrO₄, LaAlO₄, BaZrO₃ oder ähnliche Materialien.

Gemäß einer weiteren bevorzugten Weiterbildung ist das leitende Füllmaterial aus einer ersten leitenden Füllschicht im unteren Grabenbereich und einer zweiten leitenden Füllschicht im oberen Grabenbereich zusammengesetzt.

Ausführungsbeispiele der vorliegenden Erfindung sind in den Zeichnungen dargestellt und werden in der nachfolgenden Beschreibung näher erläutert.

In den Figuren zeigen:
- Fig. 1a-n: die zum Verständnis der Erfindung wesentlichen Verfahrensschritte zur Herstellung eines ersten Ausführungsbeispiels des erfindungsgemäßen Grabenkondensators;
- Fig. 2a-m: die zum Verständnis der Erfindung wesentlichen Verfahrensschritte zur Herstellung eines zweiten Ausführungsbeispiels des erfindungsgemäßen Grabenkondensators;
- Fig. 3a-h: die zum Verständnis der Erfindung wesentlichen Verfahrensschritte zur Herstellung eines dritten Ausführungsbeispiels des erfindungsgemäßen Grabenkondensators;
- Fig. 4a-d: die zum Verständnis der Erfindung wesentlichen Verfahrensschritte zur Herstellung eines vierten Ausführungsbeispiels des erfindungsgemäßen Grabenkondensators;
- Fig. 5a-e: die zum Verständnis der Erfindung wesentlichen Verfahrensschritte zur Herstellung eines fünften Ausführungsbeispiels des erfindungsgemäßen Grabenkondensators;
- Fig. 6a-h: die zum Verständnis der Erfindung wesentlichen Verfahrensschritte zur Herstellung eines sechsten Ausführungsbeispiels des erfindungsgemäßen Grabenkondensators;
- Fig. 7a-d: die zum Verständnis der Erfindung wesentlichen Verfahrensschritte zur Herstellung eines siebenten Ausführungsbeispiels des erfindungsgemäßen Grabenkondensators;
- Fig. 8a-g: die zum Verständnis der Erfindung wesentlichen Verfahrensschritte zur Herstellung eines achten Ausführungsbeispiels des erfindungsgemäßen Grabenkondensators;
- Fig. 9a-h: die zum Verständnis der Erfindung wesentlichen Verfahrensschritte zur Herstellung eines neunten Ausführungsbeispiels des erfindungsgemäßen Grabenkondensators; und
- Fig. 10a-g: die zum Verständnis der Erfindung wesentlichen Verfahrensschritte zur Herstellung eines zehnten Ausführungsbeispiels des erfindungsgemäßen Grabenkondensators.

In den Figuren bezeichnen gleiche Bezugszeichen gleiche oder funktionsgleiche Bestandteile.

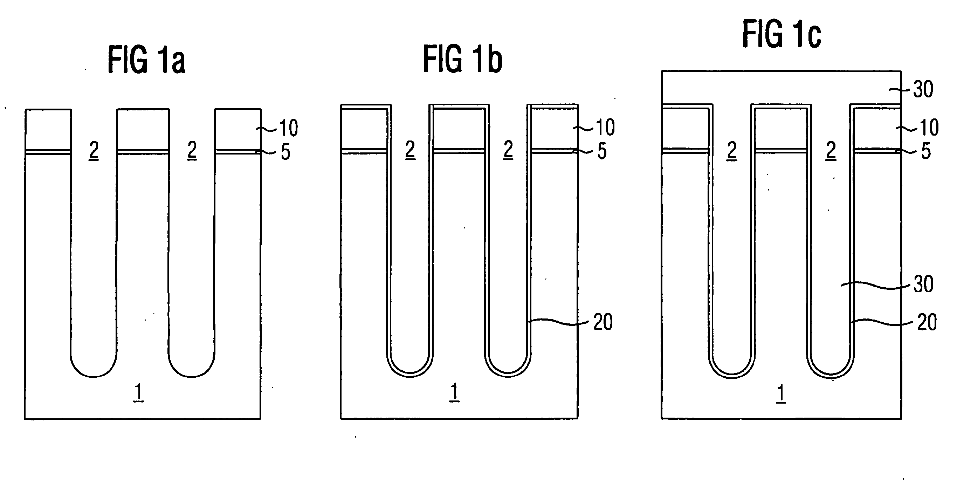

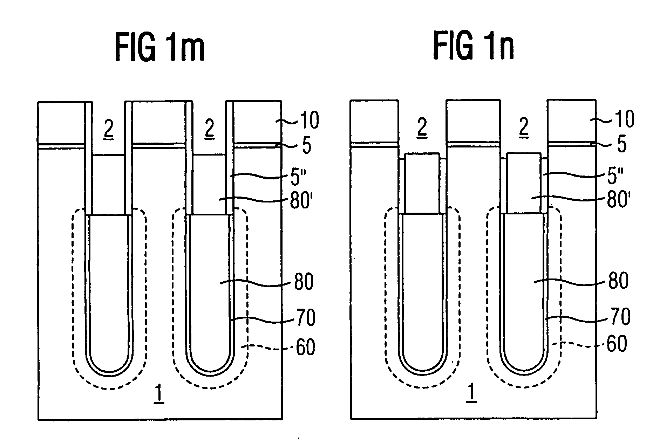

Fig. 1a-n zeigen die zum Verständnis der Erfindung wesentlichen Verfahrensschritte zur Herstellung eines ersten Ausführungsbeispiels des erfindungsgemäßen Grabenkondensators.

Bei der vorliegenden ersten Ausführungsform werden zunächst auf einem Siliziumsubstrat 1 eine Padoxidsschicht 5 und eine Padnitridschicht 10 abgeschieden, wie in Figur 1a gezeigt. Dann wird eine weitere (nicht dargestellte) Padoxidschicht abgeschieden und diese Schichten werden dann mittels einer ebenfalls nicht gezeigten Photolackmaske und einem entsprechenden Ätzverfahren zu einer sogenannten Hartmaske strukturiert. Unter Verwendung dieser Hartmaske werden Gräben 2 mit einer typischen Tiefe von circa 1-10 µm in das Siliziumsubstrat 1 geätzt. Danach wird die oberste Padoxidschicht entfernt, um zum in Fig. 1a dargestellten Zustand zu gelangen.

In einem folgenden Prozessschritt wird, wie in Figur 1b gezeigt, Arsensilikatglas (ASG) 20 auf der resultierenden Struktur abgeschieden, so daß das ASG 20 insbesondere die Gräben 2 vollständig auskleidet.

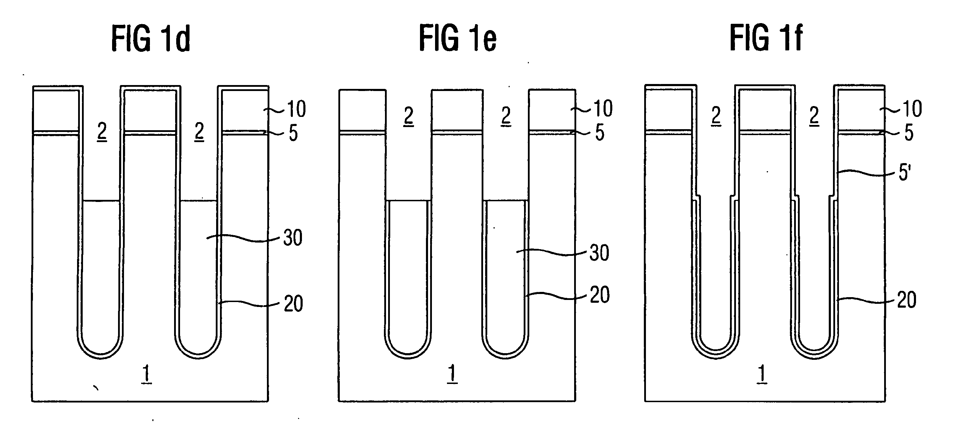

In einem weiteren Prozessschritt erfolgt, wie in Figur 1c gezeigt, ein Auffüllen der resultierenden Struktur mit Photolack 30. Gemäß Figur 1d erfolgt danach ein Lack-Recess, bzw. eine Lackentfernung im oberen Bereich der Gräben 2. Dies geschieht zweckmäßigerweise durch isotropes trockenchemisches Ätzen.

In einem weiteren Prozessschritt gemäß Figur 1e erfolgt ein ebenfalls isotropes Ätzen des ASG 20 im unmaskierten, lackfreien Bereich, und zwar vorzugsweise in einem nasschemischen Ätzprozess. Daraufhin wird der Lack 30 in einem plasmagestützten und/oder nasschemischen Prozess entfernt.

Wie in Figur 1f gezeigt, wird danach ein Deckoxid 5' auf der resultierenden Struktur abgeschieden.

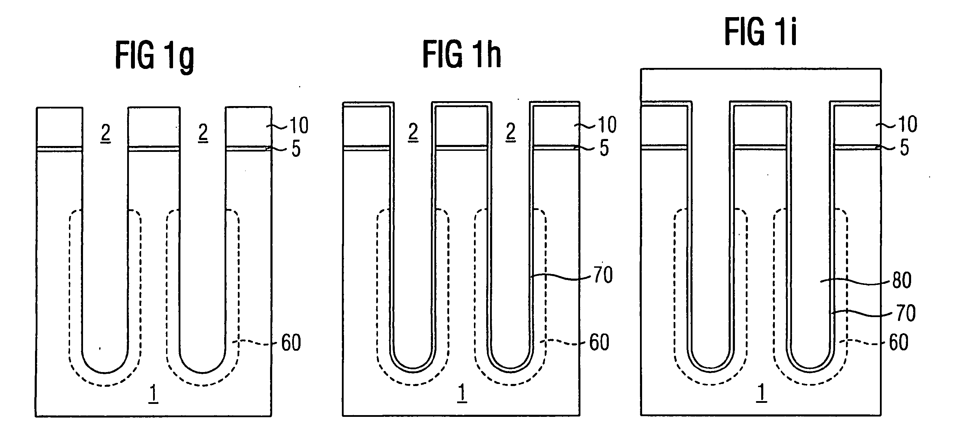

In einem weiteren Prozessschritt gemäß Fig. 1g erfolgt eine Ausdiffusion des Arsen aus dem übrig gebliebenen ASG 20 in das umliegende Siliziumsubstrat 1 in einem Temperschritt zur Bildung der vergrabenen Platte bzw. Buried Plate 60, welche eine erste Kondensatorelektrode bildet. Daran anschließend werden das Deckoxid 5' und das übrige ASG 20 zweckmäßigerweise nasschemisch entfernt.

Gemäß Figur 1h wird dann ein spezielles Dielektrikum 70 mit hoher Dielektrizitätskonstante mittels des ALD- bzw. ALCVD-Verfahrens (Atomic Layer Deposition) auf die resultierende Struktur abgeschieden. Alternativerweise kann die Abscheidung durch Atomic Layer Chemical Vapor Deposition (ALCVD) oder andere geeignete CVD-Verfahren geschehen. Als Materialien für das Dielektrikum 60 mit hoher Dielektrizitätskonstante kommen insbesondere in Betracht: Al₂ Ta₂O₅, ZrO₂, HfO₂, Y₂O₃, La₂O₃, TiO₂; Al-Ta-O, Al-Zr-O, Al-Hf-O, Al-La-O, Al-Ti-O, Zr-Y-O, Zr-Si-O, Hf-Si-O, Si-O-N, Ta-O-N und ähnliche Materialien. Diese Abscheidung kann aufgrund des ALD- bzw. ALCVD- bzw. CVD-Verfahrens mit sehr guter Gleichmäßigkeit und Konformalität durchgeführt werden.

In einem weiteren Prozessschritt wird gemäß Figur 1i als zweite Kondensatorplatte Arsen-dotiertes polykristallines Silizium 80 auf der resultierenden Struktur abgeschieden, so daß es die Gräben 2 vollständig ausfüllt. Alternativermaßen könnte auch Poly-Silizium-Germanium zur Auffüllung verwendet werden.

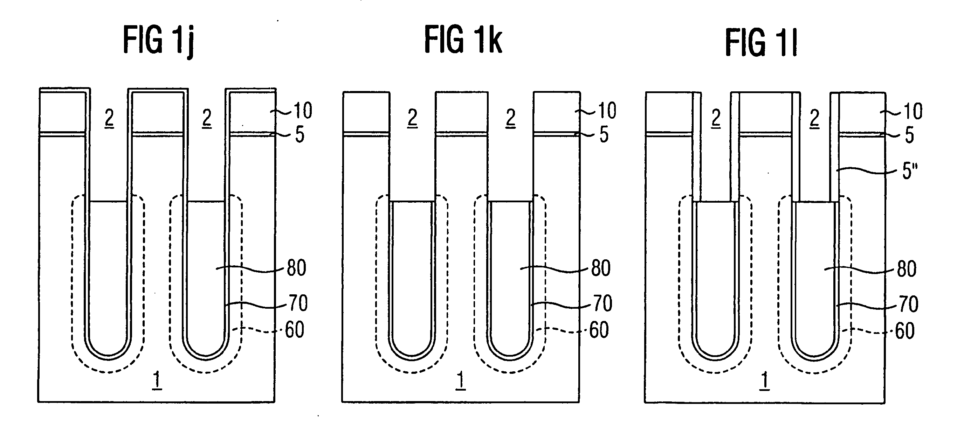

In einem darauffolgenden Prozessschritt gemäß Fig. 1j wird das dotierte Polysilizium 80, bzw. das Poly-Silizium-Germanium bis zur Oberseite der Buried Plate 60 zurückgeätzt.

Zur Erreichung des in Figur 1k dargestellten Zustands erfolgt dann ein isotropes Ätzen des Dielektrikums 70 mit hoher Dielektrizitätskonstante im oberem freigelegten Bereich der Gräben 2, und zwar entweder mit einem nasschemischen oder einem trockenchemischen Ätzverfahren.

In einem darauffolgenden Prozessschritt gemäß Fig. 1l wird ein Kragenoxid 5'' im oberen Bereich der Gräben 2 gebildet. Dies geschieht durch eine ganzflächige Oxidabscheidung und ein darauffolgendes anisotropes Ätzen des Oxids, so daß das Kragenoxid 5'' an den Seitenwänden im oberen Grabenbereich stehenbleibt.

Wie in Figur lm illustriert, wird in einem darauffolgenden Prozessschritt erneut mit Arsen dotiertes Polysilizium 80' abgeschieden und zurückgeätzt.

Gemäß Figur In folgt schließlich eine nasschemische Entfernung des Kragenoxids 5'' im oberen Grabenbereich.

Damit ist die Ausbildung des Grabenkondensators im Wesentlichen beendet. Das Bilden der Kondensatoranschlüsse sowie die Herstellung und Verbindung mit dem zugehörigen Auswahltransistor sind im Stand der Technik wohl bekannt und benötigen zur Erläuterung der vorliegenden Erfindung keiner weiteren Erwähnung.

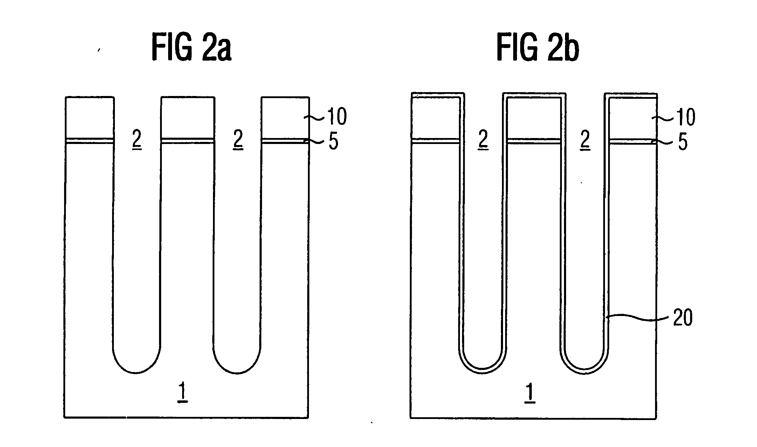

Fig. 2a-m zeigen die zum Verständnis der Erfindung wesentlichen Verfahrensschritte zur Herstellung eines zweiten Ausführungsbeispiels des erfindungsgemäßen Grabenkondensators.

Bei der obigen ersten Ausführungsform wurde der Kragen nach Abscheidung des Dielektrikums 70 mit hoher Dielektrizitätskonstante gebildet. Bei der nunmehr beschriebenen zweiten Ausführungsform erfolgt die Bildung des Kragens vor dem Abscheiden des Dielektrikums 70 mit hoher Dielektrizitätskonstante.

Insbesondere entsprechen die Prozessschritte gemäß Figur 2a und 2b den Prozessschritten, welche bereits mit Bezug auf Figur 1a und 1b erläutert wurden.

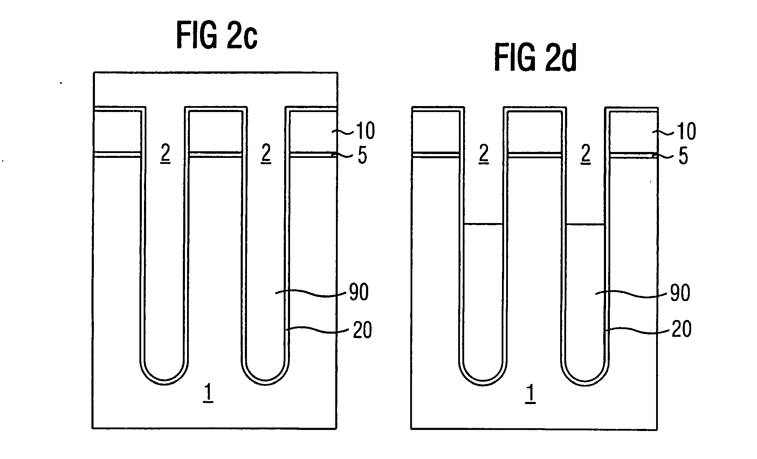

Wie in Figur 2c dargestellt, erfolgt nach der Abscheidung der ASG-Schicht 20 ein Auffüllen der resultierenden Struktur mit undotiertem polykristallinem Silizium 90, welches danach zur Erreichung des in Figur 2d gezeigten Zustandes im oberen Bereich des Grabens durch isotropes trockenchemisches Ätzen entfernt wird.

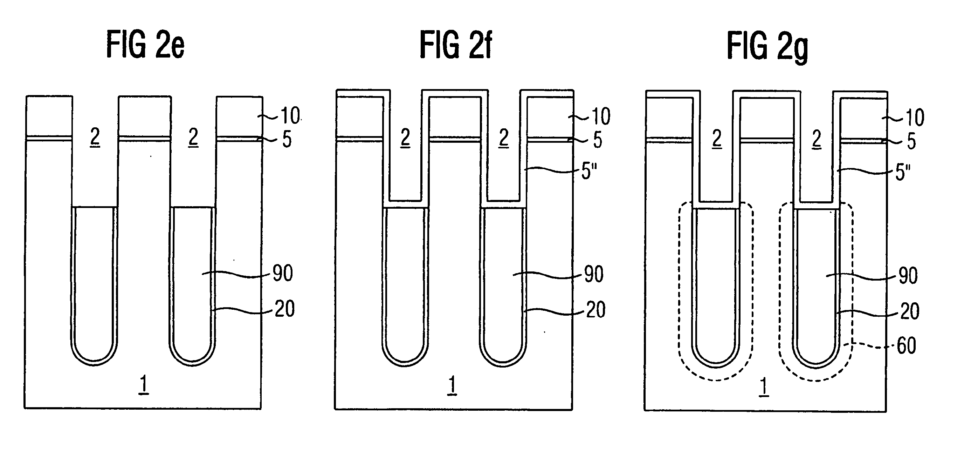

In einem weiteren Prozessschritt wird das ASG 20 im oberen freigelegten Grabenbereich durch einen nasschemischen isotropen Ätzschritt entfernt, wie in Fig. 2e gezeigt. Es folgt die ganzflächige Abscheidung des Kragenoxids 5'', wie in Figur 2f gezeigt.

Im nächsten Prozessschritt gemäß Fig. 2g wird Arsen aus dem ASG 20 in den umliegenden Bereich des Siliziumsubstrats 1 ausdiffundiert, um die Buried Plate 60 zu bilden.

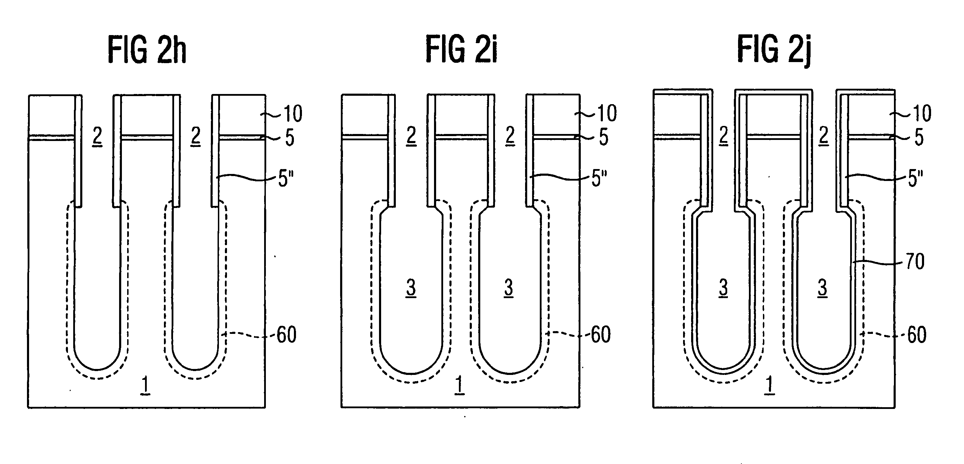

Es folgt ein anisotropes Ätzen des Kragenoxids 5'', um dies von der Oberfläche der resultierenden Struktur zu entfernen, so daß es nur noch an den Seitenwänden im oberen Bereich der Gräben 2 zurückbleibt. Danach wird das Polysilizium 90 durch isotropes Ätzen entfernt, und in einem weiteren Schritt das ASG 20 ebenfalls durch einen isotropen nasschemischen Ätzprozess entfernt. Dies führt zum in Figur 2h gezeigten Zustand.

In einem weiteren Prozessschritt erfolgt nunmehr die Bildung eines aufgeweiteten unteren Grabenbereichs 3 durch einen im Stand der Technik bekannten Ätzprozess, bzw. Wet Bottle Ätzprozess, was zu der in Figur 2i gezeigten Struktur führt.

Im nächsten Prozessschritt gemäß Fig. 2j erfolgt die Abscheidung des Dielektrikums 70 mit hoher Dielektrizitätskonstanten mittels des in Zusammenhang mit der ersten Ausführungsform bereits erwähnten ALD- bzw. ALCVD-Verfahrens bzw. CVD-Verfahrens. Die dazu besonders geeigneten Materialien mit hoher Dielektrizitätskonstante wurden ebenfalls bereits im Zusammenhang mit der ersten Ausführungsform erwähnt.

Wie aus Figur 2j ersichtlich, ist aufgrund der Besonderheit des verwendeten Abscheideverfahrens die Abdeckung der Struktur mit dem Dielektrikum 70 mit hoher Dielektrizitätskonstanten sehr gleichmäßig, was dafür sorgt, dass keine ungewollten Leckströme an kritischen Stellen, wie zum Beispiel Kanten oder stärkeren Krümmungen auftreten.

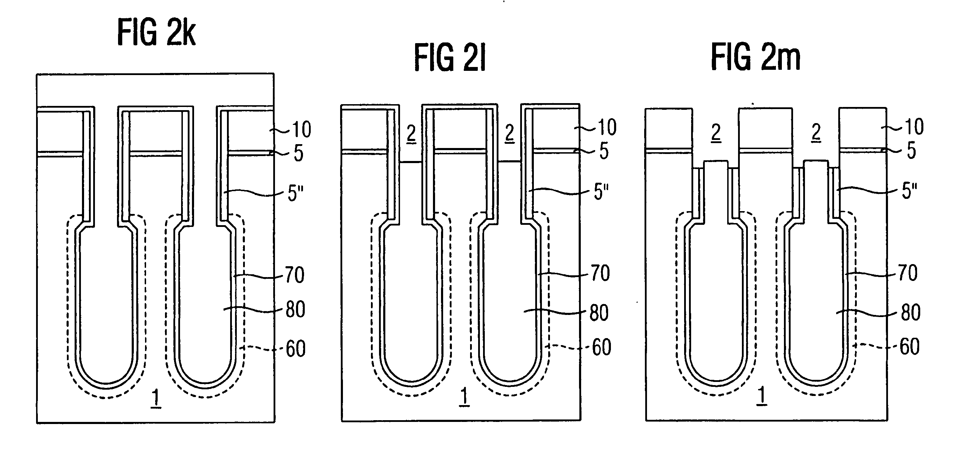

Im nächsten Prozessschritt erfolgt eine Abscheidung von Arsen-dotiertem Polysilizium 80 bzw. Poly-Silizium-Germanium, was zur in Figur 2k gezeigten Struktur führt.

Durch ein Zurückätzen des Polysiliziums bzw. Poly-Silizium-Germaniums wird die in Figur 2l dargestellte Struktur erhalten.

Schließlich erfolgt ein nasschemisches isotropes Ätzen des Dielektrikums 70 mit hoher Dielektrizitätskonstante und des Kragenoxids 5'' im oberen Bereich der Gräben 2, um die in Figur 2m dargestellte Struktur zu erhalten.

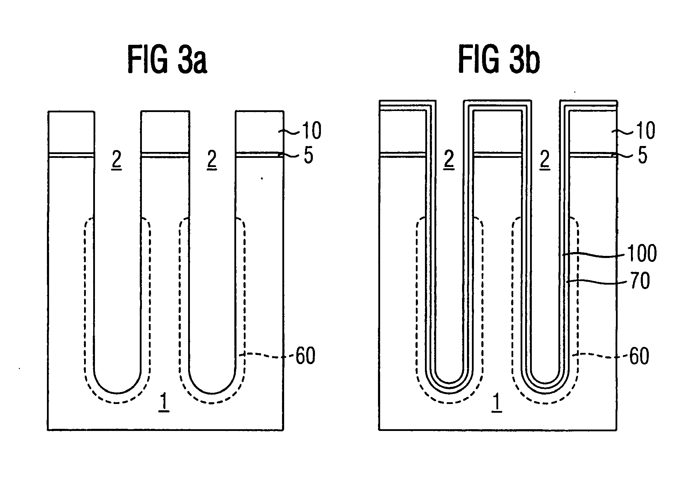

Fig. 3a-h zeigen die zum Verständnis der Erfindung wesentlichen Verfahrensschritte zur Herstellung eines dritten Ausführungsbeispiels des erfindungsgemäßen Grabenkondensators.

Bei dieser dritten Ausführungsform der Erfindung entspricht der in Figur 3a gezeigte Zustand dem in Figur 1g gezeigten Zustand, dessen Vorgeschichte bereits ausführlich erläutert wurde.

Gemäß Figur 3b wird dann das spezielle Dielektrikum 70 mit hoher Dielektrizitätskonstante mittels des ALD- bzw. ALCVD-Verfahrens auf die resultierende Struktur abgeschieden, wie im einzelnen in Zusammenhang mit Figur 1h erläutert.

Im Unterschied zur ersten Ausführungsform erfolgt daran anschließend die Abscheidung eines Metallelektrodenfilms 100 mittels des ALD- bzw. ALCVD-Verfahrens bzw. eines anderen geeigneten CVD-Verfahrens.

Als Materialien für die Metallelektrode 100 kommen insbesondere in Betracht: TiN, WN, TaN, HfN, ZrN, Ti, W, Ta, Si, TaSiN, WSiN, TiAlN, WSi, MoSi, CoSi und allgemein Metall-Silizium-Nitride oder ähnliche Materialien.

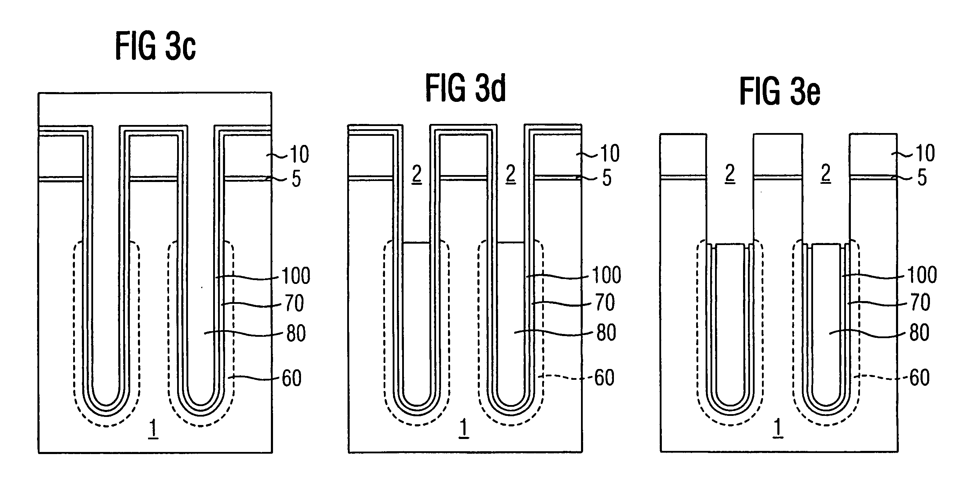

In einem weiteren Prozessschritt wird gemäß Figur 3c Arsen-dotiertes polykristallines Silizium 80 auf der resultierenden Struktur abgeschieden, so daß es die Gräben 2 vollständig ausfüllt. Alternativermaßen könnte auch Poly-Silizium-Germanium zur Auffüllung verwendet werden.

In einem darauffolgenden Prozessschritt gemäß Fig. 3d wird das dotierte Polysilizium 80 bzw. das Poly-Silizium-Germanium bis zur Oberseite der Buried Plate 60 zurückgeätzt.

Zur Erreichung des in Figur 3e dargestellten Zustands erfolgt dann ein isotropes Ätzen des Dielektrikums 70 mit hoher Dielektrizitätskonstante und der Metallelektrode 100 im oberem freigelegten Bereich der Gräben 2, und zwar entweder mit einem nasschemischen und/ oder einem trockenchemischen Ätzverfahren.

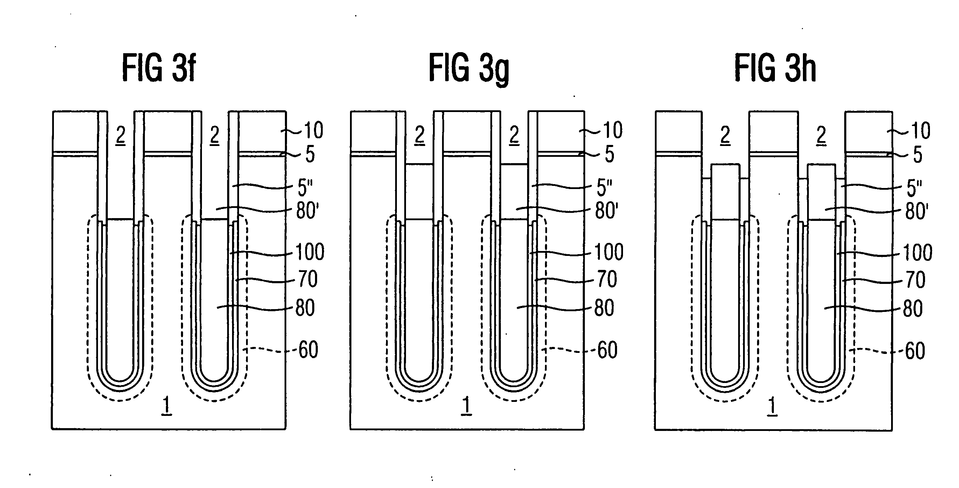

In einem darauffolgenden Prozessschritt gemäß Fig. 3f wird ein Kragenoxid 5'' im oberen Bereich der Gräben 2 gebildet. Dies geschieht durch eine ganzflächige Oxidabscheidung und ein darauffolgendes anisotropes Ätzen des Oxids, so daß das Kragenoxid 5'' an den Seitenwänden im oberen Grabenbereich stehenbleibt.

Wie in Figur 3g illustriert, wird in einem darauffolgenden Prozessschritt erneut mit Arsen dotiertes Polysilizium 80' abgeschieden und zurückgeätzt.

Gemäß Figur 3h folgt schließlich eine nasschemische Entfernung des Kragenoxids 5'' im oberen Grabenbereich.

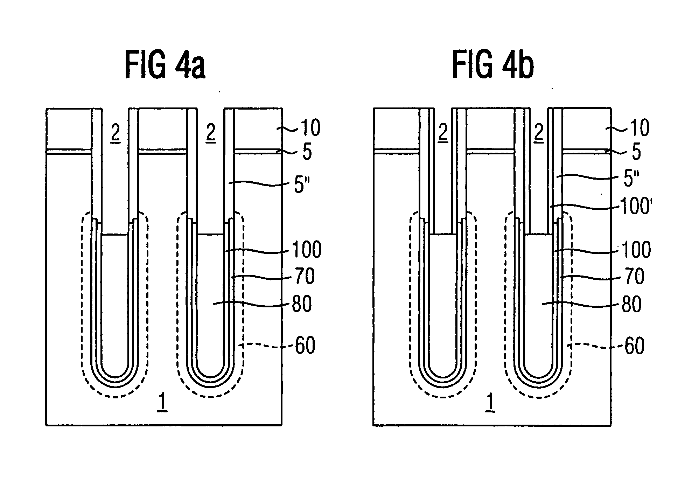

Fig. 4a-d zeigen die zum Verständnis der Erfindung wesentlichen Verfahrensschritte zur Herstellung eines vierten Ausführungsbeispiels des erfindungsgemäßen Grabenkondensators.

Der in Figur 4a dargestellte Zustand entspricht dem Zustand gemäß Figur 3f, dessen Vorgeschichte detailliert in Zusammenhang mit der obigen dritten Ausführungsform erläutert wurde, wobei allerdings unmittelbar nach dem Zustand von Figur 3f noch ein weiterer Recess des Polysiliziums 80 auf trockenchemische Art und Weise durchgeführt wurde, um die Metallelektrode 100 teilweise freizulegen.

Gemäß Figur 4b wird danach ein weiterer Metallelektrodenfilm 100' analog wie der Metallelektrodenfilm 100 abgeschieden und anisotrop zurückgeätzt, so daß er im oberen Bereich der Gräben 2 stehen bleibt. Alternativ kann auf die anisotrope Rückätzung auch verzichtet werden oder der obere Grabenbereich auch ganz mit Metall (d.h. ohne Polysilizium 80') aufgefüllt werden.

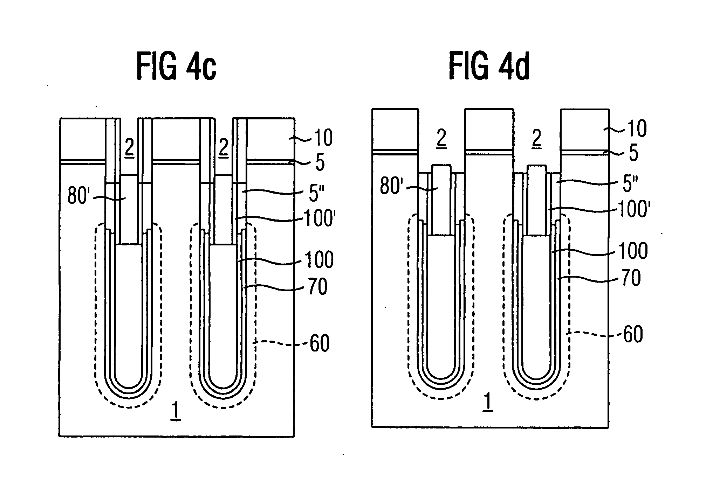

Es folgt eine Abscheidung von Arsen-dotiertem Polysilizium 80' und ein entsprechendes Zurückätzen, um den in Figur 4c dargestellten Zustand zu erreichen.

Schließlich werden gemäß Figur 4d der Metallelektrodenfilm 100' und das Kragenoxyd 5'' im oberen Bereich der Gräben 2 zweckmäßigerweise nasschemisch zurückgeätzt.

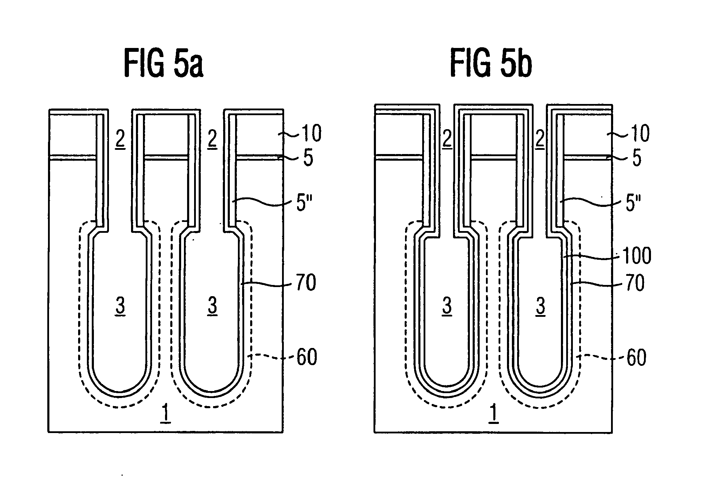

Fig. 5a-e zeigen die zum Verständnis der Erfindung wesentlichen Verfahrensschritte zur Herstellung eines fünften Ausführungsbeispiels des erfindungsgemäßen Grabenkondensators.

Der in Figur 5a dargestellte Zustand entspricht dem in Figur 2j dargestellten Zustand, dessen Vorgeschichte oben ausführlich in Zusammenhang mit der zweiten Ausführungsform erläutert wurde.

Gemäß Figur 5b wird darauffolgend der Metallelektrodenfilm 100 mittels des ALD- bzw. ALCVD-Verfahrens bzw. des CVD-Verfahrens auf der resultierenden Struktur abgeschieden, und zwar in analoger Weise wie in Zusammenhang mit Figur 3b erörtert.

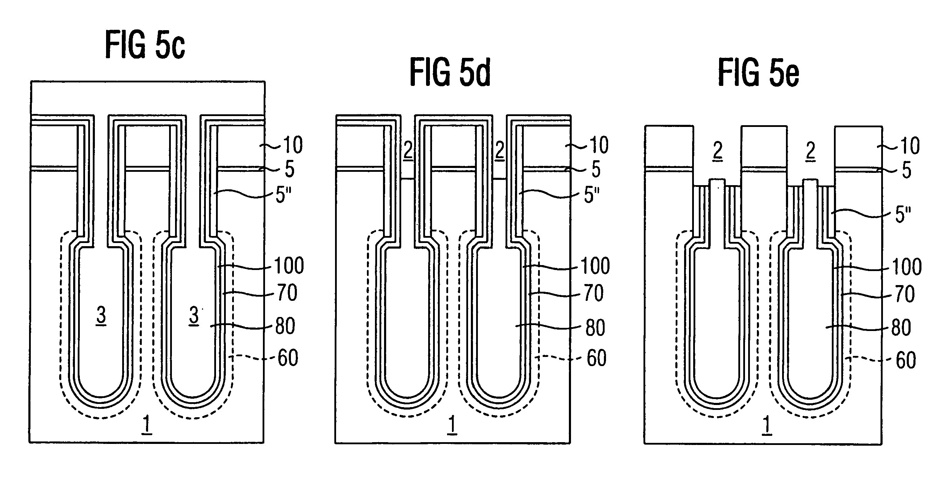

Im nächsten Prozessschritt erfolgt eine Abscheidung von Arsen-dotiertem Polysilizium 80 bzw. Poly-Silizium-Germanium, was zur in Figur 5c gezeigten Struktur führt.

Durch ein Zurückätzen des Polysiliziums bzw. Poly-Silizium-Germaniums wird die in Figur 5d dargestellte Struktur erhalten.

Schließlich erfolgt ein nasschemisches isotropes Ätzen des Metallelektrodenfilms 100, des Dielektrikums 70 mit hoher Dielektrizitätskonstante und des Kragenoxids 5'' im oberen Bereich der Gräben 2, um die in Figur 5e dargestellte Struktur zu erhalten.

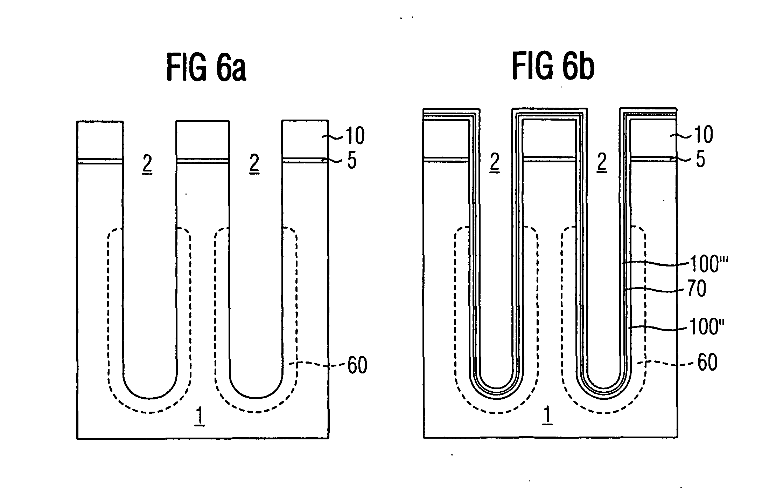

Fig. 6a-h zeigen die zum Verständnis der Erfindung wesentlichen Verfahrensschritte zur Herstellung eines sechsten Ausführungsbeispiels des erfindungsgemäßen Grabenkondensators.

Die in Figur 6a dargestellte Struktur entspricht der in Figur 1g dargestellten Struktur, deren Vorgeschichte bereits ausführlich in Zusammenhang mit der ersten Ausführungsform erläutert wurde.

Gemäß Figur 6b erfolgt daraufhin die Abscheidung einer Metall-Isolator-Metall-Struktur, bestehend aus der Metallelektrodenschicht 100'', der Dielektrikumschicht 70 und der Metallelektrodenschicht 100'''. Die Abscheideverfahren und die für diese Schichten verwendeten Materialien entsprechen denjenigen der oben erläuterten ersten bzw. dritten Ausführungsform, und eine wiederholte Beschreibung derselben wird deshalb hier unterlassen.

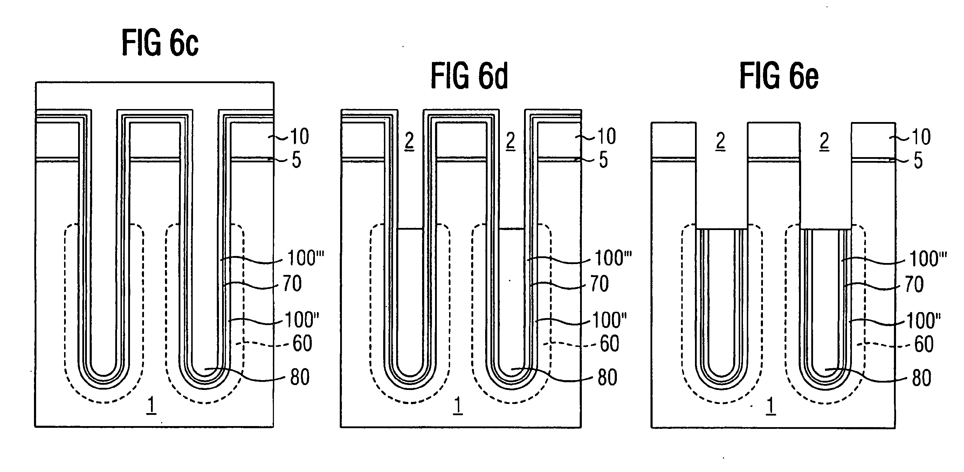

In einem weiteren Prozessschritt wird gemäß Figur 6c Arsen-dotiertes polykristallines Silizium 80 auf der resultierenden Struktur abgeschieden, so daß es die Gräben 2 vollständig ausfüllt. Alternativermaßen könnte auch Poly-Silizium-Germanium zur Auffüllung verwendet werden.

In einem darauffolgenden Prozessschritt gemäß Fig. 6d wird das dotierte Polysilizium 80, bzw. das Poly-Silizium-Germanium bis zur Oberseite der Buried Plate 60 zurückgeätzt.

Zur Erreichung des in Figur 6e dargestellten Zustands erfolgt dann ein isotropes Ätzen der Metallelektrodenschichten 100'' und 100" und des Dielektrikums 70 mit hoher Dielektrizitätskonstante im oberem freigelegten Bereich der Gräben 2, und zwar entweder mit einem nasschemischen oder einem trokkenchemischen Ätzverfahren.

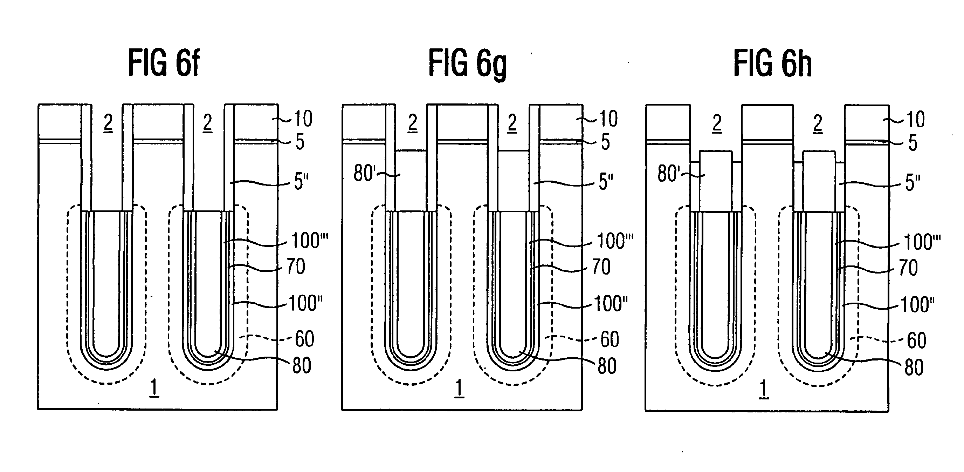

In einem darauffolgenden Prozessschritt gemäß Fig. 6f wird ein Kragenoxid 5'' im oberen Bereich der Gräben 2 gebildet. Dies geschieht durch eine ganzflächige Oxidabscheidung und ein darauffolgendes anisotropes Ätzen des Oxids, so daß das Kragenoxid 5'' an den Seitenwänden im oberen Grabenbereich stehenbleibt.

Wie in Figur 6g illustriert, wird in einem darauffolgenden Prozessschritt erneut mit Arsen dotiertes Polysilizium 80' abgeschieden und zurückgeätzt.

Gemäß Figur 6h folgt schließlich eine nasschemische Entfernung des Kragenoxids 5'' im oberen Grabenbereich.

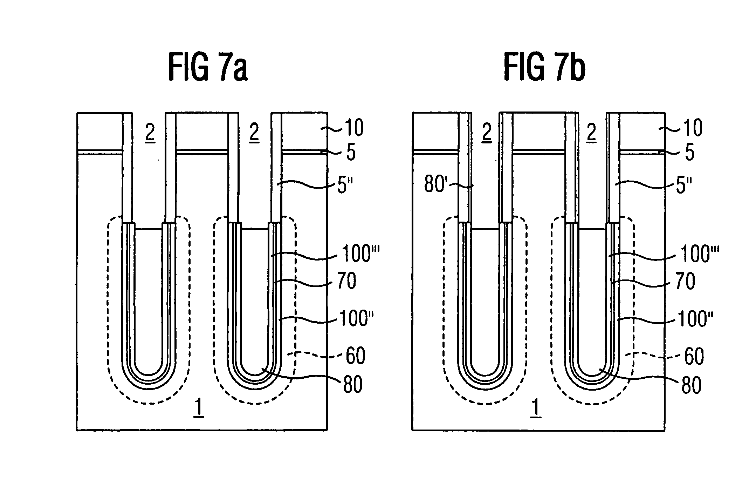

Fig. 7a-d zeigen die zum Verständnis der Erfindung wesentlichen Verfahrensschritte zur Herstellung eines siebenten Ausführungsbeispiels des erfindungsgemäßen Grabenkondensators.

Der in Figur 7a dargestellte Zustand entspricht dem in Figur 6f dargestellten Zustand, wobei ein weiterer Recess an dem Polysilizium 80 durchgeführt wurde, so daß die Metallelektrodenschicht 100''' teilweise im Graben 2 freigelegt ist.

Gemäß Figur 7b wird in einem darauffolgenden Prozessschritt die weitere Metallelektrodenschicht 100' abgeschieden und anisotrop geätzt, so daß die Metallelektrodenschicht 100' die Innenwände im oberen Bereich des Grabens 2 auskleidet. Alternativ kann auf die anisotrope Rückätzung auch verzichtet werden oder der obere Grabenbereich auch ganz mit Metall (d.h. ohne Polysilizium 80') aufgefüllt werden.

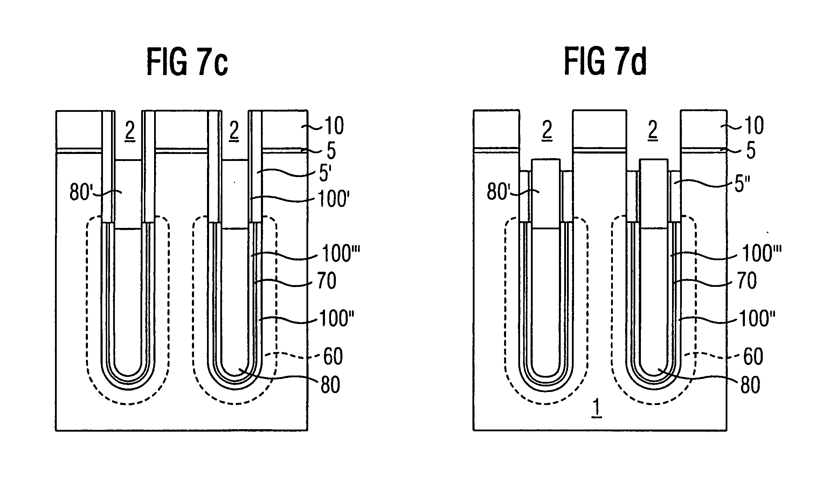

Im nächsten Prozessschritt erfolgt eine Abscheidung von Arsen-dotiertem Polysilizium 80' bzw. Poly-Silizium-Germanium. Durch ein Zurückätzen des Polysiliziums bzw. Poly-Silizium-Germaniums wird die in Figur 7c dargestellte Struktur erhalten.

Schließlich erfolgt ein nasschemisches isotropes Ätzen des Metallelektrodenfilms 100' und des Kragenoxids 5'' im oberen Bereich der Gräben 2, um die in Figur 7d dargestellte Struktur zu erhalten.

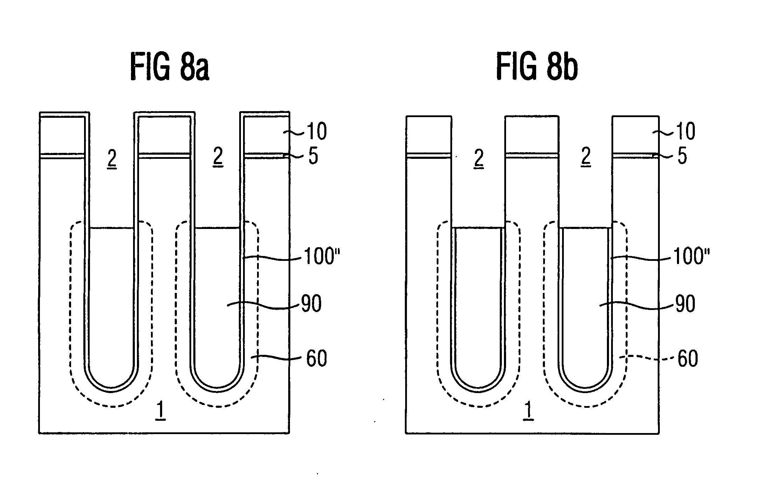

Fig. 8a-g zeigen die zum Verständnis der Erfindung wesentlichen Verfahrensschritte zur Herstellung eines achten Ausführungsbeispiels des erfindungsgemäßen Grabenkondensators.

Die in Figur 8a gezeigte Struktur entspricht der in Figur 1g gezeigten Struktur, wobei auf der Struktur nach Figur 1g ein Metallelektrodenfilm 100'' gemäß dem ALD- bzw. CVD- Verfahren, wie oben erläutert, abgeschieden wurde. Weiterhin wurde über der so erhaltenen Struktur undotiertes Polysilizium 90 abgeschieden und bis zur Oberseite der Buried Plate 60 zurückgeätzt.

Gemäß Figur 8b erfolgt dann ein Zurückätzen des Metallelektrodenfilms 100'' im freigelegten Bereich durch einen entsprechenden isotropen Ätzprozess.

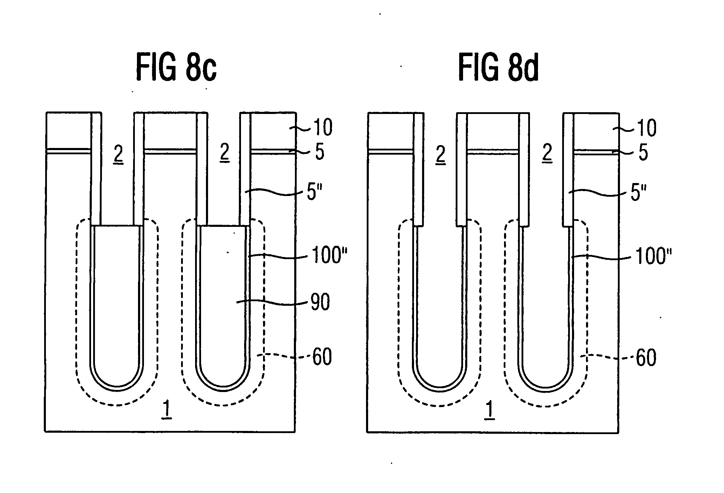

Gemäß Figur 8c wird dann das Kragenoxyd 5'' abgeschieden und anisotrop zurückgeätzt, wie bereits oben beschrieben. Es folgt ein Entfernen des undotierten Polysiliziums 90 im unteren Grabenbereich, was zur in Figur 8d gezeigten Struktur führt.

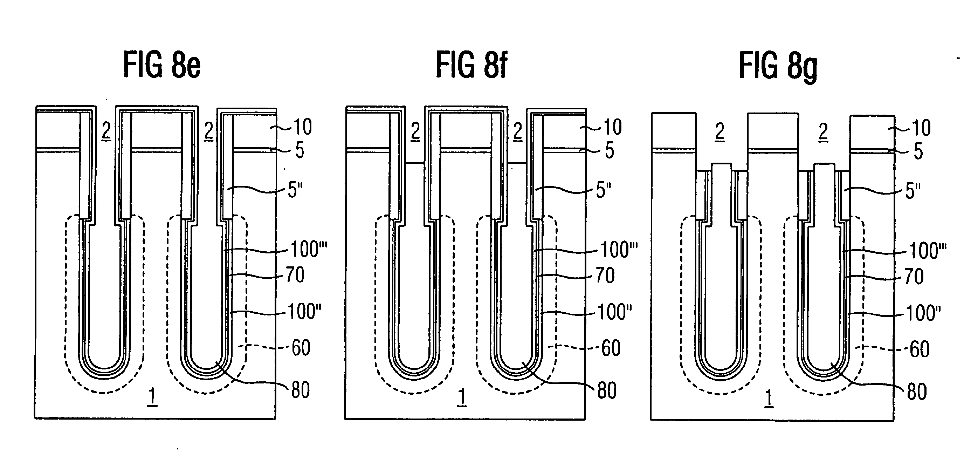

In einem nächsten Prozessschritt, der in Figur 8e gezeigt ist, erfolgt ein Abscheiden des speziellen Dielektrikums 70 mit hoher Dielektrizitätskonstante und der weiteren Metallelektrodenschicht 100'''.

Auf der resultierenden Struktur wird ganzflächig mit Arsen dotiertes Polysilizium 80 abgeschieden und zurückgeätzt, wie in Figur 8f dargestellt.

Schließlich werden die Metallelektrodenschicht 100''', die Dielektrikumschicht 70 und das Kragenoxyd 5'' im oberen Bereich zurückgeätzt, um die in Figur 8g gezeigte Struktur zu erhalten.

Diese achte Ausführungsform erlaubt es, dass der Kragen selbstjustiert zur unteren Metallelektrode 100'' angeordnet ist.

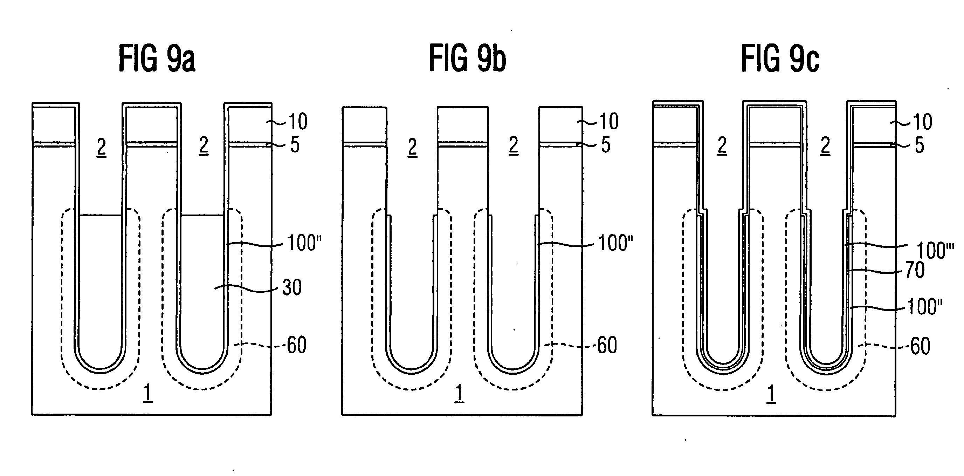

Fig. 9a-h zeigen die zum Verständnis der Erfindung wesentlichen Verfahrensschritte zur Herstellung eines neunten Ausführungsbeispiels des erfindungsgemäßen Grabenkondensators.

Gemäß Figur 9a erfolgt eine Abscheidung der Metallelektrodenschicht 100'' auf die in Figur 1g gezeigte Struktur, auf die Photolack 30 aufgebracht und zurückgeätzt wurde.

Gemäß Figur 9b erfolgt danach ein Zurückätzen der Metallelektrodenschicht 100'' und ein Entfernen des Photolacks 30 durch einen entsprechenden Ätzprozess.

Wie in Figur 9c dargestellt, werden dann auf der resultierenden Struktur die Dielektrikumschicht 70 mit hoher Dielektrizitätskonstante und die weitere Metallelektrodenschicht 100''' abgeschieden.

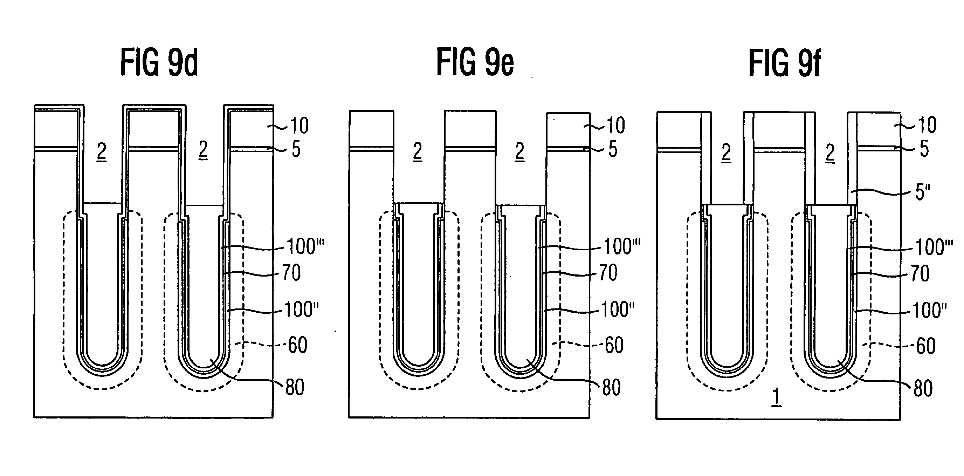

Wie in Figur 9d gezeigt, wird auf der resultierenden Struktur Arsen-dotiertes Polysilizium 80 abgeschieden und bis oberhalb des Bereichs der Buried Plate 60 zurückgeätzt.

In einem darauffolgenden isotropen Ätzschritt werden die Metallelektrodenschicht 100"' und die Dielektrikumschicht 70 ebenfalls zurückgeätzt, um die in Figur 9e gezeigte Struktur zu erhalten.

In einem darauffolgenden Prozessschritt gemäß Fig. 9f wird ein Kragenoxid 5'' im oberen Bereich der Gräben 2 gebildet. Dies geschieht durch eine ganzflächige Oxidabscheidung und ein darauffolgendes anisotropes Ätzen des Oxids, so daß das Kragenoxid 5'' an den Seitenwänden im oberen Grabenbereich stehenbleibt.

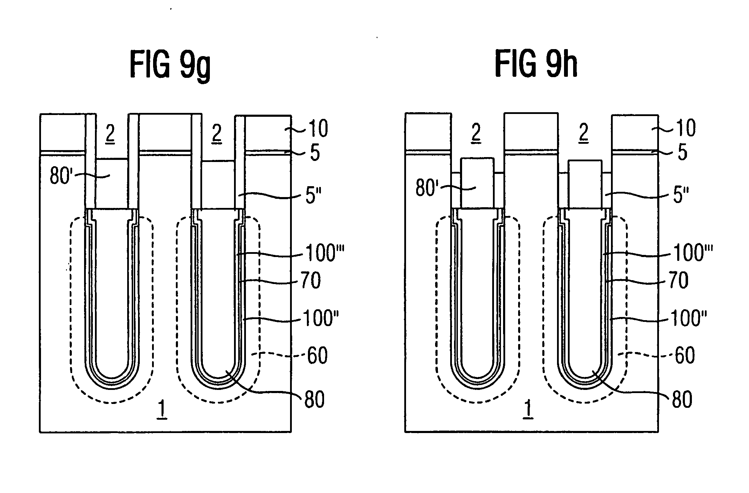

Wie in Figur 9g illustriert, wird in einem darauffolgenden Prozessschritt erneut mit Arsen dotiertes Polysilizium 80' abgeschieden und zurückgeätzt.

Gemäß Figur 9h folgt schließlich eine nasschemische Entfernung des Kragenoxids 5'' im oberen Grabenbereich.

Bei der in Figur 9a bis h illustrierten neunten Ausführungsform ist der Kragen selbstjustiert zum Dielektrikum 70 und zur oberen Elektrode 100''' aufgebracht.

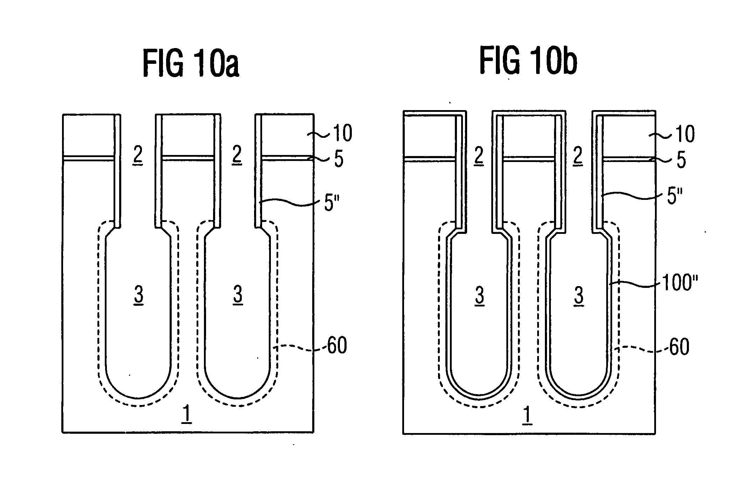

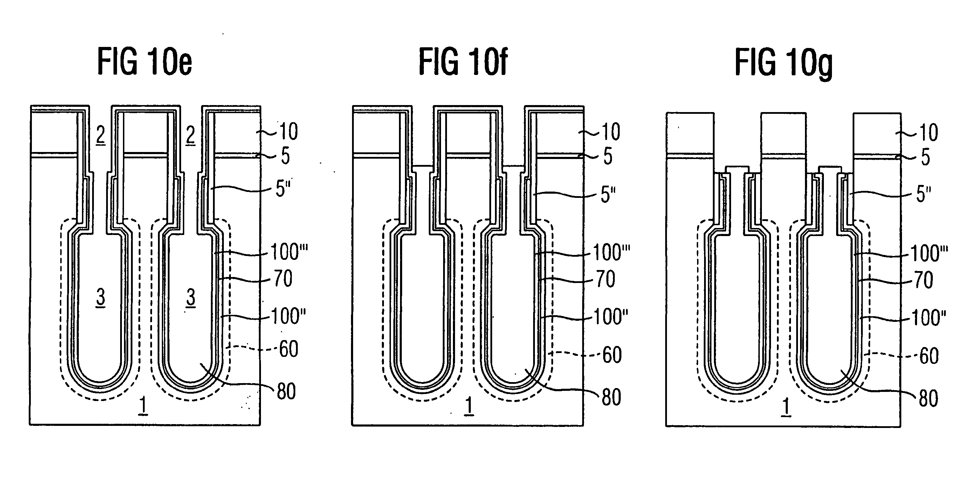

Fig. 10a-g zeigen die zum Verständnis der Erfindung wesentlichen Verfahrensschritte zur Herstellung eines zehnten Ausführungsbeispiels des erfindungsgemäßen Grabenkondensators.

Der in Figur 10a gezeigte Zustand entspricht dem Zustand gemäß Figur 2i, dessen Vorgeschichte bereits ausführlich in Zusammenhang mit der obigen zweiten Ausführungsform erläutert wurde.

Zum Erreichen des in Figur 10b gezeigten Zustands wird auf der resultierenden Struktur die Metallelektrodenschicht 100'' abgeschieden.

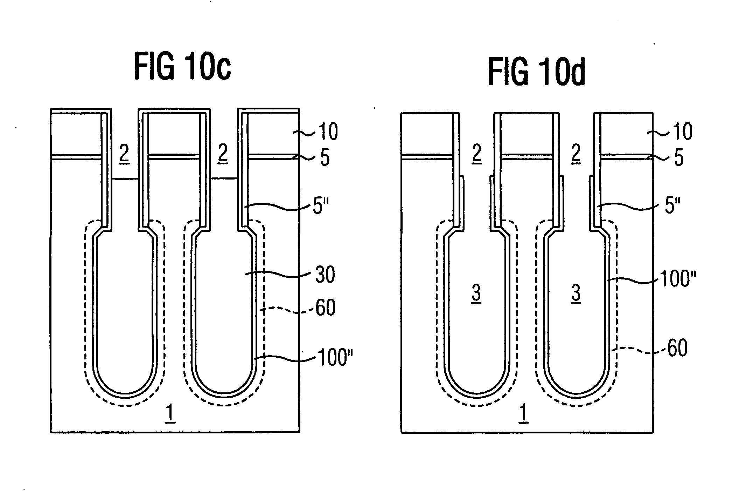

Es folgt ein Auffüllen der Struktur mit Photolack 30 und ein Zurückätzen des Photolacks 30, um zu der in Figur 10c gezeigten Struktur zu gelangen. Danach erfolgt ein Zurückätzen der Metallelektrodenschicht 100'' im freigelegten Bereich und danach ein Entfernen des Photolacks 30. Dies ist in Figur 10d dargestellt.

Anschließend werden das spezielle Dielektrikum 70 mit hoher Dielektrizitätskonstante sowie die weitere Metallelektrodenschicht 100''' auf der resultierenden Struktur abgeschieden.

Es folgt ein Abscheiden und Zurückätzen von Arsen-dotiertem Polysilizium 80 oder Polysilizium-Germanium. Dies führt zu der in Figur 10f gezeigten Struktur.

Schließlich werden die beiden Metallelektrodenschichten 100'' und 100''', die Dielektrikumschicht 70 und das Kragenoxid 5'' im oberen Bereich zurückgeätzt, um die in Figur 10g gezeigte Struktur zu erhalten

Obwohl die vorliegende Erfindung vorstehend anhand eines bevorzugten Ausführungsbeispiels beschrieben wurde, ist sie darauf nicht beschränkt, sondern auf vielfältige Art und Weise modifizierbar.

Insbesondere sind die angeführten Materialien nur beispielhaft und durch andere Materialien mit geeigneten Eigenschaften ersetzbar. Dasgleiche gilt für die genannten Ätzprozesse und Abscheidungsprozesse.

### Bezugszeichenliste

- 1: Siliziumsubstrat
- 3: aufgeweiteter Bereich
- 5: Padoxid
- 5': Deckoxid
- 5'': Kragenoxid
- 10: Padnitrid
- 20: ASG
- 30: Photolack
- 60: Buried Plate
- 70: Dielektrikum
- 80, 80': dotiertes Polysilizium
- 90: undotiertes Polysilizium
- 100, 100', 100'', 100''': Metallelektrodenschicht

## Patentansprüche

1. Grabenkondensator, insbesondere zur Verwendung in einer Halbleiter-Speicherzelle, mit:
einem Graben (2), der in einem Halbleitersubstrat (1) gebildet ist;
einer im Graben (2) befindlichen ersten und zweiten leitenden Kondensatorplatte (60, 80; 60, 100; 100'', 100''');
einer zwischen der ersten und zweiten Kondensatorplatte (60, 80; 60, 100; 100'', 100''') befindlichen dielektrischen Schicht (70) als Kondensatordielektrikum;
einem Isolationskragen (5'') im oberen Bereich des Grabens (2); und
einem in den Graben (2) gefüllten leitenden Füllmaterial (80'); **dadurch gekennzeichnet daß**
zwischen der dielektrischen Schicht (70) und dem Halbleitersubstrat (1) eine dritte Metallelektrodenschicht (100") als erste Kondensatorplatte und andererseits der dielektrischen Schicht (70) eine vierte Metallelektrodenschicht (100"') als zweite Kondensatorplatte vorgesehen ist.

2. Grabenkondensator nach Anspruch 1,
**dadurch gekennzeichnet,**
**daß** im oberen Bereich des Grabens (2) eine zweite Metallelektrodenschicht (100') vorgesehen ist, welche mit der vierten Metallelektrodenschicht (100"') in elektrischer Verbindung steht, wobei die zweite Metallelektrodenschicht (100') optionellerweise den oberen Grabenbereich ausfüllt.

3. Grabenkondensator nach Anspruch 1 oder 2,
**dadurch gekennzeichnet,**
**daß** die dielektrische Schicht (70) und die vierte Metallelektrodenschicht (100''') in den Bereich des Isolationskragens (5'') geführt sind.

4. Grabenkondensator nach Anspruch 3,
**dadurch gekennzeichnet,**
**daß** die dritte Metallelektrodenschicht (100") in den Bereich des Isolationskragens (5'') geführt ist.

5. Grabenkondensator nach einem der Ansprüche 1 bis 4,
**dadurch gekennzeichnet,**
**daß** die erste oder zweite oder dritte oder vierte Metallelektrodenschicht (100, 100', 100" , 100") oder die dielektrische Schicht (70) durch ein ALD- bzw. ALCVD-Verfahren oder ein CVD-Verfahren aufgebracht worden ist.

6. Grabenkondensator nach einem der Ansprüche 1 bis 4,
**dadurch gekennzeichnet,**
**daß** die erste oder zweite oder dritte oder vierte Metallelektrodenschicht (100, 100', 100'', 100''') mindestens eines der folgenden Materialien aufweist:
TiN, WN, TaN, HfN, ZrN, Ti, W, Ta, TaSiN, WSiN, TiAlN, WSi, MoSi, CoSi.

7. Grabenkondensator nach einem der vorhergehenden Ansprüche,
**dadurch gekennzeichnet,**
**daß** der Graben (2) einen unteren aufgeweiteten Bereich (3) aufweist.

8. Grabenkondensator nach einem der vorhergehenden Ansprüche,
**dadurch gekennzeichnet,**
**daß** die dielektrische Schicht (70) mindestens eines der folgenden Materialien aufweist:
Al₂O₃, Ta₂O₅, ZrO₂, HfO₂, Y₂O₃, La₂O₃, TiO₂; Al-Ta-O, Al-Zr-O, Al-Hf-O, Al-La-O, Al-Ti-O, Zr-Y-O, Zr-Si-O, Hf-Si-O, Si-O-N, Ta-O-N, Gd₂O₃, S_{C2}O₃, La-Si-O, Ti-Si-O, LaAlO₃, ZrTiO₄, (Zr, Sn) TiO₄, SrZrO₄, LaAl₃O₄, BaZrO₃.

9. Grabenkondensator nach einem der vorhergehenden Ansprüche,
**dadurch gekennzeichnet,**
**daß** das leitende Füllmaterial (80, 80') aus einer ersten leitenden Füllschicht (80) im unteren Grabenbereich und einer zweiten leitenden Füllschicht (80') im oberen Grabenbereich zusammengesetzt ist.

10. Verfahren zur Herstellung eine Grabenkondensators, insbesondere zur Verwendung in einer Halbleiter-Speicherzelle, mit den Schritten:
Bilden eines Grabens (2) in einem Halbleitersubstrat (1);
Vorsehen einer ersten und zweiten leitenden Kondensatorplatte (60, 80; 60, 100; 100'', 100''') im Graben (2);
Vorsehen einer dielektrischen Schicht (70) als Kondensatordielektrikum zwischen der ersten und zweiten Kondensatorplatte (60, 80; 60, 100; 100'', 100''');
Bilden eines Isolationskragens (5'') im oberen Bereich des Grabens (2); und
Auffüllen eines leitenden Füllmaterials (80, 80') in den Graben (2);
wobei zwischen der dielektrischen Schicht (70) und dem Halbleitersubstrat (1) eine dritte Metallelektrodenschicht (100") als erste Kondensatorplatte und andererseits der dielektrischen Schicht (70) eine vierte Metallelektrodenschicht (100"') als zweite Kondensatorplatte vorgesehen wird:

11. Verfahren nach Anspruch 10,
**dadurch gekennzeichnet,**
**daß** zwischen dem Isolationskragen (5") und dem leitenden Füllmaterial (80, 80') im oberen Bereich des Grabens (2) eine zweite Metallelektrodenschicht (100') vorgesehen wird, welche mit der vierten Metallelektrodenschicht (100"') in elektrischer Verbindung steht.

12. Verfahren nach Anspruch 10 oder 11,
**dadurch gekennzeichnet,**
**daß** die dielektrische Schicht (70) und die vierte Metallelektrodenschicht (100''') in den Bereich des Isolationskragens (5'') geführt werden.

13. Verfahren nach Anspruch 12,
**dadurch gekennzeichnet,**
**daß** die dritte Metallelektrodenschicht (100''') in den Bereich des Isolationskragens (5'') geführt wird.

14. Verfahren nach einem der Ansprüche 10 bis 13,
**dadurch gekennzeichnet,**
**daß** die erste oder zweite oder dritte oder vierte Metallelektrodenschicht (100, 100', 100'', 100''') oder die dielektrische Schicht (70) durch ein ALD- bzw. ALCVD-Verfahren oder ein CVD-Verfahren aufgebracht wird.

## Claims

1. Trench capacitor, in particular for use in a semiconductor memory cell, with:
a trench (2), which is formed in a semiconductor substrate (1);
a first and second conducting capacitor plate (60, 80; 60, 100; 100" , 100'''), located in the trench (2);
a dielectric layer (70), located between the first and second capacitor plates (60, 80; 60, 100; 100'', 100"'), as the capacitor dielectric;
an isolation collar (5") in the upper region of the trench (2) ; and
a conducting filling material (80, 80'), filled into the trench (2);
**characterized in that**
a third metal electrode layer (100") is provided between the dielectric layer (70) and the semiconductor substrate (1) as the first capacitor plate and a fourth metal electrode layer (100"') is provided on the other side of the dielectric layer (70) as the second capacitor plate.

2. Trench capacitor according to Claim 1, **characterized in that** a second metal electrode layer (100') is provided in the upper region of the trench (2) and is in electrical connection with the fourth metal electrode layer (100"'), the second metal electrode layer (100') optionally filling the upper trench region.

3. Trench capacitor according to Claim 1 or 2, **characterized in that** the dielectric layer (70) and the fourth metal electrode layer (100''') are led into the region of the isolation collar (5'').

4. Trench capacitor according to Claim 3, **characterized in that** the third metal electrode layer (100"') is led into the region of the isolation collar (5'').

5. Trench capacitor according to one of Claims 1 to 4, **characterized in that** or second or third or fourth metal electrode layer (100, 100', 100", 100''') or the dielectric layer (70) have been applied by an ALD or ALCVD method or a CVD method.

6. Trench capacitor according to one of Claims 1 to 4, **characterized in that** the first or second or third or fourth metal electrode layer (100, 100', 100'', 100"') has at least one of the following materials:
TiN, WN, TaN, HfN, ZrN, Ti, W, Ta, TaSiN, WSiN, TiAIN, WSi, MoSi, CoSi.

7. Trench capacitor according to one of the preceding claims, **characterized in that** the trench (2) has a lower widened region (3).

8. Trench capacitor according to one of the preceding claims, **characterized in that** the dielectric layer (70) has at least one of the following materials:
Al₂O₃ Ta₂O₅, ZrO₂, HfO₂, Y₂O₃, La₂O₃, TiO₂; Al-Ta-O, Al-Zr-O, Al-Hf-O, Al-La-O, Al-Ti-O, Zr-Y-O, Zr-Si-O, Hf-Si-O, Si-O-N, Ta-O-N, Gd₂O₃, Sc₂O₃, La-Si-O, Ti-Si-O, LaAlO₃, ZrTiO₄, (Zr, Sn)TiO₄, SrZrO₄, LaAl₃O₄, BaZrO₃.

9. Trench capacitor according to one of the preceding claims, **characterized in that** the conducting filling material (80, 80') is composed of a first conducting filling layer (80) in the lower trench region and a second conducting filling layer (80') in the upper trench region.

10. Method for producing a trench capacitor, in particular for use in a semiconductor memory cell, with the steps of:
forming a trench (2) in a semiconductor substrate (1);
providing a first and second conducting capacitor plate (60, 80; 60, 100; 100'', 100"') in the trench (2);
providing a dielectric layer (70) as the capacitor dielectric between the first and second capacitor plates (60, 80; 60, 100; 100", 100"');
forming an isolation collar (5") in the upper region of the trench (2); and
filling a conducting filling material (80, 80') into the trench (2);
a third metal electrode layer (100") being provided between the dielectric layer (70) and the semiconductor substrate (1) as the first capacitor plate and a fourth metal electrode layer (100''') being provided on the other side of the dielectric layer (70) as the second capacitor plate.

11. Method according to Claim 10, **characterized in that** a second metal electrode layer (100') is provided between the isolation collar (5") and the conducting filling material (80, 80') in the upper region of the trench (2) and is in electrical connection with the fourth metal electrode layer (100''').

12. Method according to Claim 10 or 11, **characterized in that** the dielectric layer (70) and the fourth metal electrode layer (100"') are led into the region of the isolation collar (5'').

13. Method according to Claim 12, **characterized in that** the third metal electrode layer (100''') is led into the region of the isolation collar (5").

14. Method according to one of Claims 10 to 13, **characterized in that** the first or second or third or fourth metal electrode layer (100, 100', 100'', 100"') or the dielectric layer (70) is applied by an ALD or ALCVD method or a CVD method.

## Revendications

1. Condensateur en tranchée, notamment pour une utilisation dans une cellule de mémoire à semi-conducteur, comprenant:
une tranchée (2), qui est formée dans un substrat semi-conducteur (1);
des première et deuxième armatures conductrices de condensateur (60, 80; 60, 100 ; 100'', 100''') situées dans la tranchée (2);
une couche diélectrique (70), en tant que diélectrique de condensateur, située entre les première et deuxième armatures de condensateur (60, 80 ; 60, 100 ; 100", 100''') ;
un collet d'isolement (5'') dans la zone supérieure de la tranchée (2) ; et
une matière conductrice de remplissage (80') disposée dans la tranchée (2) ; **caractérisé en ce que**
il est prévu, entre la couche diélectrique (70) et le substrat semi-conducteur (1), une troisième couche formant électrode métallique (100'') en tant que première armature de condensateur et d'autre part la couche diélectrique (70), une quatrième couche formant électrode métallique (100''') en tant que deuxième armature de condensateur.

2. Condensateur en tranchée selon la revendication 1,
**caractérisé en ce qu'**il est prévu, dans la zone supérieure de la tranchée (2), une deuxième couche formant électrode métallique (100'), qui est reliée électriquement à la quatrième couche formant électrode métallique (100'''), la deuxième couche formant électrode métallique (100') pouvant facultativement remplir la zone supérieure de la tranchée.

3. Condensateur en tranchée selon la revendication 1 ou 2,
**caractérisé en ce que** la couche diélectrique (70) et la quatrième couche formant électrode métallique (100''') sont menées dans la zone du collet d'isolement (5'').

4. Condensateur en tranchée selon la revendication 3,
**caractérisé en ce que** la troisième couche formant électrode métallique (100") est menée dans la zone du collet d'isolement (5'').

5. Condensateur en tranchée selon l'une des revendications 1 à 4,
**caractérisé en ce que** la première ou la deuxième ou la troisième ou la quatrième couche formant électrode métallique (100, 100', 100", 100"') ou la couche diélectrique (70) a été déposée par un procédé de dépôt ALD ou bien ALCVD ou par un procédé de dépôt CVD.

6. Condensateur en tranchée selon l'une des revendications 1 à 4,
**caractérisé en ce que** la première ou la deuxième ou la troisième ou la quatrième couche formant électrode métallique (100, 100', 100", 100"') présente au moins l'une des matières suivantes :
TiN, WN, TaN, HfN, ZrN, Ti, W, Ta, TaSiN, WSiN, TiAlN, WSi, MoSi, CoSi.

7. Condensateur en tranchée selon l'une des revendications précédentes,
**caractérisé en ce que** la tranchée (2) présente une zone inférieure élargie (3).

8. Condensateur en tranchée selon l'une des revendications précédentes,
**caractérisé en ce que** la couche diélectrique (70) présente au moins l'une des matières suivantes :
Al₂O₃, Ta₂O₅, ZrO₂, HfO₂, Y₂O₃, La₂O₃, TiO₂ ; Al-Ta-O, Al-Zr-O, Al-Hf-O, Al-La-O, Al-Ti-O, Zr-Y-O, Zr-Si-O, Hf-Si-O, Si-O-N, Ta-O-N, Gd₂O₃, Sc₂O₃, La-Si-O, Ti-Si-O, LaAlO₃, ZrTiO₄, (Zr ; Sn) TiO₄, SrZrO₄, LaAl₃PO₄, BaZrO₃.

9. Condensateur en tranchée selon l'une des revendications précédentes,
**caractérisé en ce que** la matière conductrice de remplissage (80, 80') est composée d'une première couche conductrice de remplissage (80) dans la zone inférieure de la tranchée, et d'une seconde couche conductrice de remplissage (80') dans la zone supérieure de la tranchée.

10. Procédé de fabrication d'un condensateur en tranchée, notamment pour une utilisation dans une cellule de mémoire à semi-conducteur, comprenant les étapes consistant à :
former une tranchée (2) dans un substrat semi-conducteur (1);
prévoir des première et deuxième armatures conductrices de condensateur (60, 80 ; 60, 100 ; 100", 100''') dans la tranchée (2) ;
prévoir une couche diélectrique (70), en tant que diélectrique de condensateur, entre les première et deuxième armatures de condensateur (60, 80 ; 60, 100 ; 100'', 100''') ;
former un collet d'isolement (5'') dans la zone supérieure de la tranchée (2) ; et
remplir la tranchée (2) d'une matière conductrice de remplissage (80, 80') ;
où il est prévu, entre la couche diélectrique (70) et le substrat semi-conducteur (1), une troisième couche formant électrode métallique (100'') en tant que première armature de condensateur et d'autre part la couche diélectrique (70), une quatrième couche formant électrode métallique (100''') en tant que deuxième armature de condensateur.

11. Procédé selon la revendication 10,
**caractérisé en ce qu'**il est prévu, entre le collet d'isolement (5") et la matière conductrice de remplissage (80, 80'), dans la zone supérieure de la tranchée (2), une deuxième couche formant électrode métallique (100'), qui est reliée électriquement à la quatrième couche formant électrode métallique (100"').

12. Procédé selon la revendication 10 ou 11,
**caractérisé en ce que** la couche diélectrique (70) et la quatrième couche formant électrode métallique (100''') sont menées dans la zone du collet d'isolement (5").

13. Procédé selon la revendication 12,
**caractérisé en ce que** la troisième couche formant électrode métallique (100''') est menée dans la zone du collet d'isolement (5'').

14. Procédé selon l'une des revendications 10 à 13,
**caractérisé en ce que** la première ou la deuxième ou la troisième ou la quatrième couche formant électrode métallique (100, 100', 100'', 100''') ou la couche diélectrique (70) a été déposée par un procédé de dépôt ALD ou bien ALCVD, ou par un procédé de dépôt CVD.
